# EUROPEAN PATENT APPLICATION

(11) **EP 1 420 024 A1**
(43) Date of publication of application: **19.05.2004**
(21) Application number: 02025522.0
(22) Date of filing: 13.11.2002
(51) Int. Cl.: C07F 7/00, C07F 7/08, C07F 7/24, C07F 7/28, C07F 7/30, C07F 7/22, C23C 16/40

(54) **Precursor for chemical vapor deposition and thin film formation process using the same**

(71) Applicant: Asahi Denka Co., Ltd., Tokyo (JP)
(72) Inventor: Onozawa, Kazuhisa, Arakawa-ku, Tokyo (JP); Sato, Hiroki, Arakawa-ku, Tokyo (JP)
(74) Representative: Forstmeyer, Dietmar, Dr. rer. nat., Dipl.-Chem.

(57) **Abstract**

A precursor for chemical vapor deposition comprising a metal compound represented by formula (I): 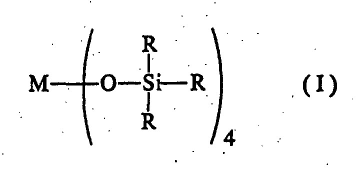 wherein a plurality of R's, which may be the same or different, each represent an alkyl group having 1 to 8 carbon atoms; and M represents a metallic element selected from the group consisting of titanium, germanium, zirconium, tin, hafnium, and lead.

## Description

### BACKGROUND OF THE INVENTION

The present invention relates to a precursor for chemical vapor deposition (CVD) which comprises a metal compound having a specific molecular structure and a CVD process for producing a thin film by using the precursor. More particularly, it relates to a precursor for CVD comprising a titanium, germanium, zirconium, tin, halfnium or lead compound having a specific molecular structure and a process of glass or ceramic thin film by CVD using the precursor.

Functional thin films containing silicon and a tetravalent metal selected from titanium, germanium, zirconium, tin, hafnium and lead are expected for application to semiconductors, electronic components, and optical components because of their unique mechanical, electrical and optical characteristics. In particular, silicate optical glass thin films are useful components of high speed high capacity communications systems, and silicate ceramic thin films are useful as gate insulators.

Optical communications system components using silicate optical glass thin films include laser oscillators, optical fibers, optical waveguides, optical amplifiers, and optical switches. For example, thin films of silicate optical glass doped with at least one metallic element selected from the group consisting of titanium, germanium, and tin find applications to optical fibers, optical waveguides, and optical switches.

Processes for making these thin films include CVD, flame hydrolysis deposition, sputtering, ion plating, and metal-organic decomposition (MOD) such as dipping-pyrolysis process and a sol-gel process. Among these thin film forming technologies, CVD is the most suitable process because of its various advantages, such as ease of composition control, excellent step coverage, similarity to the process of semiconductor device manufacture, suitability to large volume production, and capabilities of hybrid integration. e.g., germanium tetramethoxide, and trimethyltin as disclosed in *Kogyo Zairyo,* vol. 48, No. 7 (2000), JP-A-9-133827, JP-A-11-271553, and JP-A-2000-227525. CVD precursors containing titanium include alkoxides and complexes having a β-diketone as a ligand as described in JP-A-5-9738, JP-A-5-271253, and JP-A-10-114781. Similarly, CVD precursors containing zirconium or hafnium include compounds having a β-diketone and an alcohol as ligands.

However, when these tetravalent metal source precursors are combined with other precursors in making multi-component thin films, they can fail to furnish homogeneous thin films on accourit of mismatch with the other precursors in vapor pressure or decomposition behavior. For instance, in forming a silicate optical glass thin film, a dopant can be localized in the silicate glass matrix to form a heterogeneous film or a film suffering from abnormal grain growth.

While some of the metal compounds represented by formula (I) which are used in the present invention are reported in *J. Chem. Soc.* (1959), pp. 3404-3410, there is no mention of CVD using these compounds as precursors.

### SUMMARY OF THE INVENTION

An object of the present invention is to provide a precursor for CVD with which it is easy to control the composition of a CVD thin film, and which suppresses localization of a specific element, such as a dopant element.

Another object of the present invention is to provide a process of forming a thin film by using the CVD precursor.

As a result of extensive investigation, the present inventors have found that CVD using a specific metal compound as a precursor provides a thin film with a uniform composition.

The present invention provides a precursor for CVD comprising a metal compound represented by formula (I) shown below and a process of producing a thin film by using the precursor. 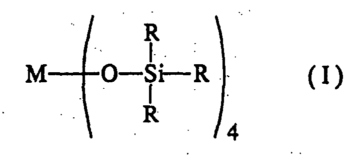 wherein a plurality of R's, which may be the same or different, each represent an alkyl group having 1 to 8 carbon atoms; and M represents a metallic element selected from the group consisting of titanium, germanium, zirconium, tin, hafnium, and lead.

### DETAILED DESCRIPTION OF THE PREFERRED EMBODIMENTS

In formula (I), the alkyl group having 1 to 8 carbon atoms as represented by R includes methyl, ethyl, propyl, isopropyl, butyl, see-butyl, t-butyl, isobutyl, amyl, isoamyl, t-amyl, hexyl, cyclohexyl, heptyl, isoheptyl, t-heptyl, n-octyl, isooctyl, t-octyl, and 2-ethylhexyl.

The metal compounds of formula (I) according to the present invention include compound Nos.1 to 15 shown below.

### Compound No. 1

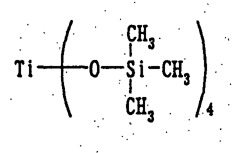

### Compound No. 2.

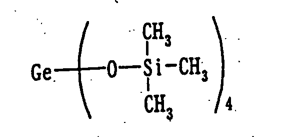

### Compound No. 3

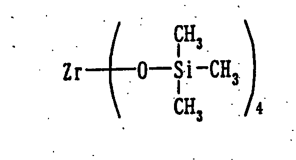

### Compound No. 4

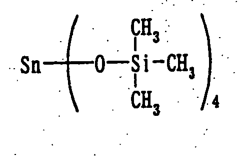

### Compound No. 5

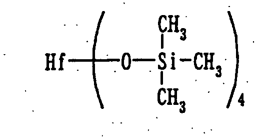

### Compound No. 6

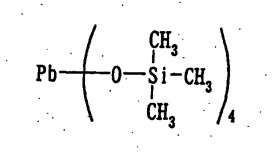

### Compound No. 7

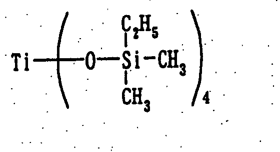

### Compound No. 8

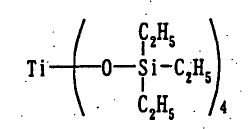

### Compound No. 9

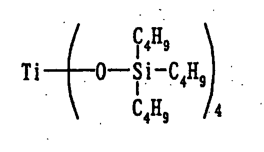

### Compound No. 10

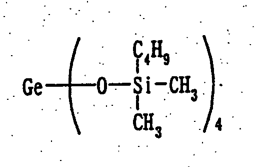

### Compound No. 11

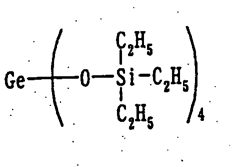

### compound No. 12

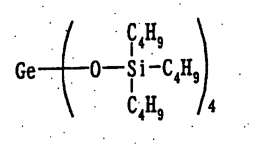

### Compound No. 13

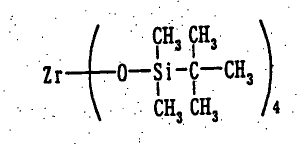

### Compound No. 14

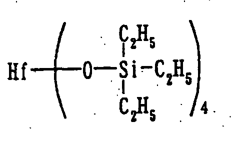

### Compound No. 15

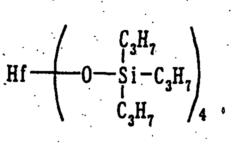

The metal compound of formula (I) can be prepared by any known process with no particular restriction. For example, it is synthesized by the reaction between an inorganic salt (e.g.; a chloride, a nitrate or a sulfate) of the tetravalent metal (i.e., Ti, Ge, Zr, Sn, Hf or Pd) or a hydrate thereof and a trialkylsilanol in the presence of a base (e.g., sodium hydroxide, ammonia or an amine), or the reaction between an inorganic salt of the tetravalent metal or a hydrate thereof and an alkoxide compound (e.g., trialkylsilyloxy sodium) obtained from a trialkylsilanol and an alkali metal, or the exchange reaction between a lower alkoxide (e.g., a tetramethoxide, a tetraethoxide, a tetraisopropoxide or a tetrabutoxide) of the tetravalent metal and a trialkylsilanol.

The term "precursor for CVD (or CVD precursor)" as used herein means a raw material comprising the above-described metal compound. The form of the precursor is selected appropriately according to, for example, the method of feeding the precursor adopted in carrying out CVD.

The methods of feeding the CVD precursor include a gas delivery system and a liquid delivery system. In a gas deliver system the CVD precursor in a container is vaporized by heating and/or vacuum evacuation and led to a deposition reaction site (the surface of a substrate) together with, if desired, a carrier gas, e.g., argon, nitrogen or helium. In a liquid delivery system the CVD precursor in a liquid or solution state is fed to a vaporization chamber, where it is vaporized by heating and/or vacuum evacuation and then led to a deposition reaction site. In a gas delivery system, the metal compound of formula (I) itself is the precursor. The precursor in a liquid delivery system is the metal compound of formula (I) itself that is liquid or a solution of the metal compound in an organic solvent.

In a multi-component CVD process for forming a multi-component thin film, the methods of feeding precursors are also divided into a multi-source system in which a plurality of monometallic precursors are used and a single source system using a mixture of a plurality of monometallic precursors at a prescribed mixing ratio. In the single source system, a mixture or a mixed solution of the metal compound of formula (I) and other metal source precursors is the CVD precursor as referred to in the present invention.

The organic solvent which can be used in liquid CVD precursors is not particularly limited, and any well-known organic solvent is useful. Examples are alcohols, such as methanol, ethanol, 2-propanol, and n-butanol; acetic esters, such as ethyl acetate, butyl acetate, and methoxyethyl acetate; ether alcohols, such as ethylene glycol monomethyl ether, ethylene glycol monoethyl ether, ethylene glycol monobutyl ether, and diethylene glycol monomethyl ether; ethers, such as tetrahydrofuran, ethylene glycol dimethyl ether, diethylene glycol dimethyl ether, triethylene glycol dimethyl ether, and dibutyl ether; ketones, such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons, such as hexane, cyclohexane, methylcyclohexane, ethylcyclohexane, heptane, octane, toluene, and xylene; hydrocarbons having a cyano group, such as 1-cyanopropane, 1-cyano-butane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; pyridine, and lutidine. A solvent to be used should be properly chosen according to, for example, solubility for the solute and the boiling temperature or ignition temperature in relation to the working temperature.

The other metal source precursors which can be used in combination with the metal compound of the present invention are not particularly limited, and any well-known CVD precursors can be used. Such precursors include organometallic compounds prepared from the metal and one or more organic ligand compounds, such as alcohol compounds, glycol compounds, β-diketone compounds, and cyclopentadiene compounds.

In the production of silicate optical glass thin films, for example, the other metal source precursors which can be used include silicon compounds, such as monosilane, disilane, trimethylsilane, triethylsilane, tetramethoxysilane, tetraethoxysilane, tetrapropoxysilane, tetraisopropoxysilane, tetrabutoxysilane, octamethylcyclotetrasiloxane, hexamethoxydisiloxane, hexaethoxydisiloxane, trimethoxy-methylsilane, triethoxymethylsilane; trimethylmethoxysilane, trimethylethoxysilane, and hexamethyldisiloxane; boron compounds, such as borane, diborane, triemthyl borate, triethyl borate, triemthylboron, and triethylboron; phosphorus compounds, such as trimethyl phosphate, triethyl phosphate, tripropyl phosphate, triisopropyl phosphate, tributyl phosphate, trimethyl phosphite, triethyl phosphite, tripropyl phosphite, and triisopropyl phosphite; silicon-boron compounds or silicon-phosphorus compounds, such as tris(trimethylsilyl) borate and dimethyl(trimethylsilyl) phosphite which are described in JP-A-2-12916; aluminum compounds, such as trimethylaluminum, triethylaluminum, tributylaluminum, trimethoxyaluminum, triethoxyaluminum, triisopropoxyaluminum, and tris(2,2,6,6-tetramethylheptane-3,5-dionato)aluminum; and rare earth element compounds, such as β-diketonato complexes of lanthanum, praseodymium, erbium; thulium, etc.

If desired, the CVD precursor according to the present invention can contain a nucleophilic reagent to stabilize the metal compound. Examples of suitable nucleophilic reagents include ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine; N,N'-tetramethylethylenediamine, diethylenetriamine; triethylenetetramine, tetraethylenepentamine, pentaethylenehexamine, 1,1,4,7,7-pentamethyldiethylenetriamine, and 1,1,4,7,10,10-hexamethyltriethylenetetramine; cyclic polyamines, such as cyclam and cyclen; β-ketonic esters or β-diketones, such as methyl acetoacetate, ethyl acetoacetate, and 2-methoxyethyl acetoacetate. The nucleophilic reagent as a stabilizer is used in an amount of 0.1 to 10 mol, preferably 1 to 4 mol, per mole of the metal compound.

The process of producing a thin film according to the present invention is by a CVD, process using the CVD precursor described *supra.* A CVD process comprises leading a vaporized precursor and, if necessary, a reactive gas to a substrate and allowing the precursor vapor to decompose and/or react to form glass or ceramic which is deposited on the substrate. The process of the present invention is not particularly restricted by the method of feeding the precursor, the mode of deposition, the production conditions, the production equipment, and so forth. Any conditions and methods well known to those skilled in the art are adoptable.

The reactive gas which can be used if desired includes oxygen, ozone, nitrogen dioxide, and nitrogen monoxide.

The methods of feeding the precursors include a gas delivery system, a liquid delivery system, a multi-source system, a single source system, and the like as described *supra.*

According to the energy applied to the vaporized precursor or a mixture of the vaporized precursor and a reactive gas, the deposition modes include thermal CVD (only heat energy is used), plasma-enhanced CVD (heat and plasma are used), photo-assisted CVD (heat and light are used), photo plasma-assisted CVD (heat, light and plasma are used), and atomic layer deposition (ALD) (an elementary reaction for forming a monomolecular layer is repeated until a desired thickness is gained).

The production conditions include temperature (the substrate temperature), pressure, and deposition rate. The temperature is preferably 200°C or higher at which the metal compounds of the present invention react sufficiently, still preferably 350 to 800°C. The pressure is from atmospheric pressure to 100 Pa for thermal CVD and photo-assisted CVD or from 100 to 2000 Pa for plasma-enhanced CVD. The deposition rate can be controlled by the precursor feed conditions (vaporizing temperature, vaporizing pressure, etc.) and the reaction temperature and pressure. Too high a deposition rate tends to result in deteriorated characteristics of the thin film, and too low a deposition rate tends to result in poor productivity. A preferred deposition rate ranges 20 to 1000 nm/min, particularly 50 to 500 nm/min.

Where step coverage is required in the process of the present invention, the resulting thin film may be subjected to the step of reflowing. reflow temperature is usually 600 to 1200°C, preferably 700 to 1000°C.

The CVD precursor of the present invention and the thin film formation process of the present invention are especially suited to the production of silicate optical glass thin films used in optical communications system components, such as optical fibers, optical waveguides, optical amplifiers, and optical switches, and the production of silicate ceramic thin films used as gate insulators of semiconductor devices.

The silicate optical glass includes silicate glass compositions comprising silicon oxide and, if desired, other oxides, such as aluminum oxide, boron oxide, phosphorus oxide, and a rare earth element (e.g., lanthanum, praseodymium, erbium or thulium) oxide, and doped with at least one dopant selected from the group consisting of titanium oxide, germanium oxide, zirconium oxide, tin oxide, hafnium oxide, and lead oxide. The molar quantity of the tetravalent metal element represented by M (see formula (I)) in such silicate optical glass is preferably 0.1 to 25 mol, still preferably 1 to 15 mol, per 100 mol of silicon.

The silicate ceramic thin film includes a complex oxide thin film represented by TiSiₓO_{y}, ZrSiₓO_{y}, HfSiₓO_{y}, etc., in which x and y are not particularly limited. Examples of such complex oxides are TiSi₁₋₄O₄₋₁₀, ZrSi₁₋₄O₄₋₁₀, and HfSi₁₋₄O₄₋₁₀.

The present invention will now be illustrated in greater detail with reference to Preparation Examples, Examples and Comparative Examples, but it should be understood that the present invention is not construed as being limited thereto.

### PREPARATION EXAMPLE 1

### Synthesis of Compound No. 13:

Into a 300 ml reactive flask purged with argon were put 33.3 g of zirconium tetraisopropoxide-isopropyl alcohol adduct (Zr(O-iPr)₄·iPr-OH), 50.1 g of dried cyclohexane (water content: ≤1 ppm), and 50.1 g of dimethyl-t-butylsilanol, and the mixture was stirred at 90°C for 5 hours while removing isopropyl alcohol. Cyclohexane was removed by evaporation, and the residue was subjected to fractional distillation under reduced pressure. The distillate obtained under a pressure of 40 to 60 Pa at a column top temperature of 140 to 145°C was collected and further purified by distillation. The first 5 wt% fraction and the final 6 wt% fraction were cut to obtain 43.5 g (yield: 82%) of a colorless transparent solid, which was analyzed by ¹H-NMR, elemental analysis, and differential thermal analysis (DTA).
¹H-NMR (δ (ppm); multiplicity; number of H atoms):
(0.15; s; 24) (1.01; s; 36)

| Elemental analysis (wt%): | | | |
|---|---|---|---|
| Calcd. | C 46.77; | Si 18.23; | Zr 14.80 |
| Found | C 46.4 ; | Si 18.2 ; | Zr 14.7 |

DTA (argon 100 ml/min; temp. rise: 10°C/min):
50% Weight loss temp.: 244°C;
100% weight loss temp.: 268°C;
melting point: 80-82°C

### PREPARATION EXAMPLE 2

### Synthesis of Compound No. 14:

Into a 300 ml reactive flask purged with argon were put 32.8 g of hafnium tetraisopropoxide-isopropyl alcohol adduct (Hf(O-iPr)₄·iPr-OH), 63.3 g of dried toluene (water content: ≤1 ppm), and 40.1 g of triethylsilanol, and the mixture was stirred at 120°G for 8 hours while removing isopropyl alcohol. Toluene was removed by evaporation, and the residue was subjected to fractional distillation under reduced pressure. The distillate obtained under a pressure of 80 to 100 Pa at a column top temperature of 140 to 165°C was collected and further purified by distillation. The first 5 wt% fraction and the final 7 wt% fraction were cut to obtain 37.7 g (yield: 78%) of a colorless transparent liquid, which was analyzed by ¹H-NMR, elemental analysis, and DTA.
¹H-NMR (δ (ppm); multiplicity; number of H atoms):
(0.60-0.69; q; 24)
(1.04-1.16; t; 36)

| Elemental analysis (wt%): | | | |
|---|---|---|---|
| Calcd. | C 41.97; | Si 25.37; | Hf 15.97 |
| Found | C 41.0: | Si 25.3 : | Hf 15.9 |

DTA (argon 100 ml/min; temp. rise: 10°C/min):
50% Weight loss temp.: 257°C;
100% weight loss temp.: 278°C

### EXAMPLES 1 TO 8 AND COMPARATIVE EXAMPLES 1 AND 2

A 20 µm thick silicate optical glass thin film was formed on a 6 in. silicon wafer (substrate) by a CVD process under the following conditions.

### Example 1:

Precursor (temp.): compound No. 1 (75°C)
Precursor delivery: gas delivery
Deposition mode: thermal CVD
Reactive gas: ozone and oxygen
Reaction pressure: 400 to 800 Pa
Substrate temperature: 450°C
Deposition rate: 150nm/min

### Example 2:

Precursor (temp.): compound No. 1 (110°C) + hexamethyldisiloxane (10°C)
Precursor delivery: gas delivery, multi-source
Deposition mode: thermal CVD
Reactive gas: ozone and oxygen
Reaction pressure: atmospheric
Substrate temperature: 450°C
Deposition rate: 170 nm/min

### Exemple 3:

Precursor (temp.): compound No. 1 (100°C) + tetraethoxysilane (55°C)
Precursor delivery: gas delivery, multi-source
Deposition mode: thermal CVD
Reactive gas: ozone and oxygen
Reaction pressure: 800 to 1000 Pa
Substrate temperature: 450°C
Deposition rate: 210 nm/min

### Example 4:

Precursor (temp.): compound No. 1 (100°C) + hexamethyldisiloxane (10°C) .
Precursor delivery: gas delivery, multi-source
Deposition mode: thermal CVD
Reactive gas: ozone and oxygen
Reaction pressure: 1000 to 1200 Pa
Substrate temperature: 450°C
Deposition rate: 220 nm/min

### Example 5:

Precursor (temp.): compound No. 1 (75°C) + tris(trimethylsilyl) borate (30°C)
Precursor delivery: gas delivery, multi-source
Deposition mode: thermal CVD
Reactive gas: ozone and oxygen
Reaction pressure: 400 to 800 Pa
Substrate temperature: 450°C
Deposition rate: 170 nm/min

### Example 6:

Precursor (temp.): compound No. 2 (120°C)
Precursor delivery: gas delivery
Deposition mode: plasma-enhanced CVD
Reactive gas: oxygen
RF output: 150 W
Reaction pressure: 300 to 500 Pa
Substrate temperature: 400°C
Deposition rate: 120 nm/min

### Example 7:

Precursor (temp.): compound No: 2 (120°C) + octamethylcyclotetrasiloxane (40°C)
Precursor delivery: gas delivery, multi-source
Deposition mode: thermal CVD
Reactive gas: ozone and oxygen
Reaction pressure: 400 to 650 Pa
Substrate temperature: 450°C
Deposition rate: 145 nm/min

### Example 8:

Precursor (temp.): compound No. 2 (130°C) + tetraethoxysilane (50°C) + trimethyl borate (20°C)
Precursor delivery: gas delivery, multi-source
Deposition mode: thermal CVD
Reactive gas: ozone and oxygen
Reaction pressure: 400 to 800 Pa
Substrate temperature: 450°C
Deposition rate: 170 nm/min

### Comparative Example 1:

Precursor (temp.): titanium tetraisopropoxide (55°C) + tetraethoxysilane (65°C)
Precursor delivery: gas delivery, multi-source
Deposition mode: thermal CVD
Reactive gas: ozone And oxygen
Reaction pressure: 600 to 1000 Pa
Substrate temperature: 450°C
Deposition rate: 180 nm/min

### Comparative Example 2:

Precursor (temp.): germanium tetramethoxide (50°C) + octamethylcyclotetrasiloxane (40°C)
Precursor delivery: gas delivery, multi-source
Deposition mode: thermal CVD
Reactive gas: ozone and oxygen
Reaction pressure: 600 to 1000 Pa
Substrate temperature: 450°C
Deposition rate: 170 nm/min

### Evaluation:

The thin films formed in Examples and Comparative Examples were subjected to energy dispersive X-ray (EDX) elemental analysis. The analysis was made at four points per sample (the positional relation of the four points in a sample was the same among all the samples). Scatter of the composition was evaluated by comparison between the highest (of A point) and the lowest (of B point) of the ratios of the dopant element to 100 mol of silicon. The results obtained are shown in Tables 1 to 3 below.

**TABLE 1**

| Silicate Glass (dopant: Ti) | | |
|---|---|---|
| | A Point | B Point |
| Example 1 | Si:Ti=100:25.18 | Si:Ti=100:25.14 |
| Example 3 | Si:Ti=100:9.670 | Si:Ti=100:9.646 |
| Comp. Example 1 | Si:Ti=100:10.44 | Si:Ti=100:9.526 |

**TABLE 2**

| Silicate Glass (dopant: Ge) | | |
|---|---|---|
| | A Point | B Point |
| Example 6 | Si:Ge=100:25.13 | Si:Ge=100:25.09 |
| Example 7 | Si:Ge=100:6.429 | Si:Ge=100:6.404 |
| Comp. Example 2 | Si:Ge=100:7.021 | Si:Ge=100:6.307 |

**TABLE 3**

| Borosilicate Glass (dopant: Ti or Ge) | | |
|---|---|---|
| | A Point | B Point |
| Example 5 | Si:B:Ti=100:14.41:14.01 | Si:B:Ti=100:14.36:13.97 |
| Example 8 | Si:B:Ge=100:10.21:5.773 | Si:B:Ge=100:10.13:5.741 |

### EXAMPLE 9

A 20 µm thick silicate ceramic thin film was formed on a 6 in silicon wafer (substrate) by a CVD process under the following conditions.
Precursor (temp.): compound No. 13 (140°C)
Precursor delivery: gas delivery
Deposition mode: thermal CVD
Reactive gas: oxygen
Reaction pressure: 100 to 200 Pa
Substrate temperature: 450°C
Deposition rate: 88 nm/min

The resulting thin film was analyzed by EDX. The Si:Zr molar ratio was found to be 100:26.01.

### EXAMPLE 10

A 20 µm thick silicate ceramic thin film was formed on a 6 in. silicon wafer (substrate) by a CVD process under the following conditions.
Precursor (temp.): compound No. 14 (155°C)
Precursor delivery: gas delivery
Deposition mode: thermal CVD
Reactive gas: oxygen
Reaction pressure: 100 to 200 Pa
Substrate temperature: 450°C
Deposition rate: 90 nm/min

The resulting thin film was analyzed by EDX. The Si:Hf molar ratio was found to be 100:25.62.

The present invention provides a CVD precursor with which it is easy to control the composition of a CVD thin film and which suppresses localization of a specific element, such as a dopant element. The present invention also provides a process of forming a thin film by using the precursor.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A precursor for chemical vapor deposition comprising a metal compound represented by formula (I): 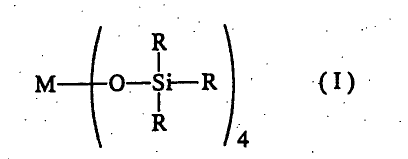 wherein the residues R, which may be the same or different, represent an alkyl group having 1 to 8 carbon atoms; and M represents a metallic element selected from the group consisting of titanium, germanium, zirconium, tin, hafnium, and lead.

2. The precursor for chemical vapor deposition according to claim 1, wherein M in formula (I) is titanium or germanium.

3. The precursor for chemical vapor deposition according to claim 1, wherein M in formula (I) is zirconium or hafnium.

4. A process of producing a thin film by chemical vapor deposition comprising using a precursor according to any one of claims 1 to 3.

5. A process of producing a silicate optical glass thin film by chemical vapor deposition comprising using a precursor according to claim 2.

6. A process of producing a silicate ceramic thin film by chemical vapor deposition comprising using a precursor according to claim 3.
